(19) Europäisches Patentamt
European Patent Office
Office européen des brevets

(11) **EP 3 155 490 B1**

(12) **EUROPÄISCHE PATENTSCHRIFT**

(45) Veröffentlichungstag und Bekanntmachung des Hinweises auf die Patenterteilung:
**03.04.2019 Patentblatt 2019/14**

(21) Anmeldenummer: **14747886.1**

(22) Anmeldetag: **25.07.2014**

(51) Int Cl.:
***G05B 23/02*** *(2006.01)*

(86) Internationale Anmeldenummer:
**PCT/EP2014/066073**

(87) Internationale Veröffentlichungsnummer:
**WO 2016/012056 (28.01.2016 Gazette 2016/04)**

(54) **VERFAHREN, ANORDNUNG, UND COMPUTERPROGRAMMPRODUKT FÜR EINE ZUSTANDSBASIERTE BERECHNUNG EINES WARTUNGSTERMINS EINER TECHNISCHEN ANLAGE**

METHOD, ARRANGEMENT AND COMPUTER PROGRAM PRODUCT FOR A CONDITION-BASED CALCULATION OF A MAINTENANCE DATE OF A TECHNICAL INSTALLATION

PROCÉDÉ, DISPOSITIF ET LOGICIEL DE CALCUL, BASÉ SUR DES ÉTATS, D'UNE DATE DE MAINTENANCE D'UNE INSTALLATION TECHNIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**19.04.2017 Patentblatt 2017/16**

(73) Patentinhaber: **Siemens Aktiengesellschaft 80333 München (DE)**

(72) Erfinder:
- **CELIK, Serdar 90409 Nürnberg (DE)**
- **KAISER, Norbert 90542 Eckental (DE)**

(56) Entgegenhaltungen:
**EP-A1- 2 549 415          DE-A1-102007 029 248**
**DE-A1-102010 049 909**

EP 3 155 490 B1

**Beschreibung**

Die Erfindung betrifft ein Verfahren für eine Zustandsüberwachung einer technischen Anlage.

Bei der Zustandsüberwachung technischer Anlagen werden häufig Daten aus unterschiedlichen Quellen verwendet, um fundierte Entscheidungen über den Zustand einer Anlage zu treffen und ggf. nötige Wartungen oder Anlagenersetzungen durchzuführen. Oft sind die dabei verwendeten Daten nicht aktuell, sondern einmal erfasste statische Messwerte.

Unter technischen Anlagen sind dabei beispielsweise elektrische Anlagen wie Transformatoren oder gasisolierte Schaltanlagen zu verstehen. Es kann sich jedoch bei einer technischen Anlage auch um nicht-elektrische Anlagen wie beispielsweise mechanische Anlagen handeln. Beispiele für eine mechanische Anlage sind Zementmühlen, Hubbrücken oder Rohrleitungsnetze mit eingebauten Betriebsmitteln wie etwa Schiebern, Pumpen und Mengenmessern. Eine andere Art von Anlagen, die im Sinne der Erfindung überwacht werden können, sind Gebäude wie etwa Häuser oder Stadien.

Derzeit werden i.d.R. online - Zustandsüberwachungen technischer Anlagen vorgenommen, um bestehende Fehlfunktionen schnell zu erkennen und entsprechende Reparatur- oder Wartungsaufträge auszulösen. Die Entscheidung, wann bei einer funktionierenden Anlage eine Wartung oder Ersetzung nötig ist, wird anhand der Erfahrung eines Wartungstechnikers, Erfahrungswerten zur Lebensdauer des betreffenden Anlagentyps und Kostenerwägungen getroffen.

Aus der Tagungsveröffentlichung "Dynamic Fleet Wide Condition Assessment Tool of Power Transformers" von L. Cheim, P. Lorin und P. Khanna, "Trafotech 2014 - Session V: Towards Maintenance Free Transformers", ist ein Verfahren für eine automatische Zustandsüberwachung einer technischen Anlage bekannt.

Aus der Druckschrift EP 2549415 A1 ist ein Verfahren gemäß dem Oberbegriff des Anspruchs 1 bekannt. Weitere Verfahren zur Zustandsüberwachung von Anlagen sind aus den Druckschriften DE 10 2010 049909 A1 und DE 10 2007 029248 A1 bekannt.

An die Erfindung stellt sich die Aufgabe, ein gattungsgemäßes Verfahren bereit zu stellen, mit dem ein Betriebszustand für technische Anlagen vergleichsweise präzise ermittelt werden kann, um Ausfälle der Anlagen zu vermeiden.

Die Erfindung löst diese Aufgabe durch ein Verfahren gemäß Anspruch 1.

Dabei ist erfindungsgemäß unter einem Betriebszustand ein Wert zu verstehen, der den technischen Zustand einer im Betrieb befindlichen technischen Anlage angibt und verschiedene technische Anlagen vergleichbar macht. Ein Beispiel für einen solchen Wert ist der bei so genannten "Condition Monitoring"-Systemen häufig vorkommende "health index", der beispielsweise Werte zwischen 0 und 10 annehmen kann, wobei der Wert 10 für eine alte Anlage mit hohem Abnutzungsgrad steht.

Ein wesentlicher Vorteil des erfindungsgemäßen Verfahrens besteht darin, dass mittels des mittels des mindestens einen Messwerts ermittelten aktuellen Betriebszustands der technischen Anlage unter Berücksichtigung von Alterungserscheinungen in der Anlage ein zukünftiger zeitlicher Verlauf des Betriebszustands automatisch ermittelt wird; mittels dieses voraussichtlichen zeitlichen Verlaufs kann beispielsweise zu einem beliebigen späteren Zeitpunkt der dann gegebene Betriebs zustand der technischen Anlage festgestellt werden. Aus in der Regel vorbekannten Zusammenhängen von Betriebsstand und Wartungsintervall bei der jeweiligen Anlage ist dann der nächste Wartungstermin festlegbar.

Dadurch, dass die Festlegung des nächsten Wartungstermins auf dem mindestens einen Messwert der technischen Anlage basiert, der i.d.R. online erhoben wird, können funktionierende Anlagen also optimal lange genutzt werden, bevor eine Wartung ausgelöst werden muss. Hierdurch werden Kosten für die Wartung eingespart. Es ist ein besonderer Vorteil des erfindungsgemäßen Verfahrens, dass ein online-Zustandsüberwachungssystem mit einem bisher offline betriebenen Wartungsmanagement verknüpft werden kann.

Die Einbeziehung komponentenspezifischer Alterungsfunktionen für die Ermittlung des zukünftigen zeitlichen Verlaufs des Betriebszustands macht es mit Vorteil möglich, eine zukünftige Verschlechterung des Betriebszustands vorherzusagen, weil die Alterungsfunktionen den zeitlichen Verlauf der zukünftig erwarteten Betriebszustände beeinflussen bzw. bei der Ermittlung des zukünftigen zeitlichen Verlaufs des Betriebszustands berücksichtigt sind.

Dies ist weiterhin vorteilhaft, weil durch die Alterungsfunktion Erfahrungswerte für das Altern einer Komponente automatisch einbezogen werden können. So kann eine Anlage stets so spät wie möglich gewartet werden, bevor ein Fehler oder Ausfall droht.

Die Anpassung des Wartungsintervalls für die Anlage macht es möglich, beispielsweise bei einer Herstellerangabe für ein Wartungsintervall von 5 Jahren, dieses Intervall bei einem vergleichsweise schlechten Betriebszustand der Anlage auf 3 Jahre zu verkürzen und entsprechend einen früheren Wartungstermin festzusetzen, was Kosten einspart, weil die Anlage bereits vor einem Fehlerfall gewartet werden kann.

In einer bevorzugten Ausführungsform des erfindungsgemäßen Verfahrens wird als Anlage ein Transformator, eine gasisolierte Schaltanlage oder eine luftisolierte Schaltanlage verwendet. Dies ist vorteilhaft, weil diese Arten von Anlagen erfahrungsgemäß Alterungsprozessen unterliegen und regelmäßig gewartet und/oder ersetzt werden müssen.

In einer weiteren bevorzugten Ausführungsform des erfindungsgemäßen Verfahrens wird die Festlegung des nächsten Wartungstermins anhand des mindestens einen erfassten Messwerts ständig aktualisiert. Dies ist ein Vorteil, weil durch eine solche online-Überwachung der technischen Anlage stets alle verfügbaren Daten aktuell gehalten und zur Festlegung des Wartungstermins verwendet werden.

In einer weiteren bevorzugten Ausführungsform des erfindungsgemäßen Verfahrens wird das Wartungsintervall angepasst, indem ein vorgegebenes Wartungsintervall jeweils für einen nachfolgenden Zeitpunkt mit festgelegtem zeitlichen Abstand zum aktuellen Datum unter Berücksichtigung des aus dem zukünftigen zeitlichen Verlauf des Betriebszustands bekannten Betriebszustands an dem nachfolgenden Zeitpunkt angepasst wird, wobei das zum nachfolgenden Zeitpunkt bestimmte Wartungsintervall ein vorgegebenes Wartungsintervall für den nächsten nachfolgenden Zeitpunkt ist, bis das Wartungsintervall so verkleinert ist, dass es mit einem nachfolgenden Zeitpunkt zusammenfällt. Dies ist ein Vorteil, weil mit diesem iterativen Ansatz besonders leicht und mit geringem Rechenaufwand ein Wartungstermin berechnet werden kann. Dabei wird zum Beispiel jeweils für jeden Monat ab dem aktuellen Datum der dann zu erwartende Betriebszustand, der sich aufgrund der Alterung der Anlage von Monat zu Monat verschlechtert, herangezogen und für eine entsprechende Verringerung des Wartungsintervalls eingesetzt. Dabei ist es jedoch auch möglich, dass sich das Wartungsintervall aufgrund eines gegenüber den Herstellerangaben verlängert, weil die Anlage nur wenig abgenutzt ist und ein guter Betriebszustand vorliegt.

Es wird der Betriebszustand der technischen Anlage aus mehreren Betriebsteilzuständen ermittelt, wobei den einzelnen Betriebsteilzuständen jeweils einzelne Komponenten der Anlage zugeordnet sind und wobei die einzelnen Betriebsteilzustände jeweils gewichtet herangezogen werden. Dies ist ein Vorteil, weil auf diese Weise besonders präzise der Betriebszustand berechnet werden kann. Insbesondere die Gewichtung macht es möglich, beispielsweise besonders fehleranfällige Komponenten stark zu berücksichtigen, damit der

Wartungstermin stets vor einem Ausfall der Anlage erfolgen kann.

Beispielsweise können bei einer gasisolierten Schaltanlage im Hochspannungsbereich die Betriebsteilzustände Isolationssystem, Antriebsmechanismus, Trennfähigkeit und andere Faktoren verwendet werden.

In einer weiteren bevorzugten Ausführungsform des erfindungsgemäßen Verfahrens wird die Gewichtung eines einzelnen Betriebsteilzustands anhand eines vorbekannten gesamten Fehleraufkommens bei dem Typ der Anlage bestimmt, indem für die zugeordneten Komponenten der relative Anteil bestimmt wird, den diese Komponenten am gesamtem Fehleraufkommen haben. Dies ist vorteilhaft, weil es auf diese Weise möglich wird, die unterschiedlichsten Messdaten, die von Sensoren an einer Anlage geliefert werden, mit unterschiedlicher Gewichtung zur Berechnung des Betriebszustands einzusetzen, wobei jeweils die fehleranfälligsten Betriebszustandsdimension am stärksten in den gesamten Betriebszustand eingehen.

Im Hochspannungsbereich wird bei einer gasisolierten Schaltanlage mit 132 kV Nennspannung beispielsweise folgende Gewichtung vorgenommen: Isolationssystem (IS) 50,7%, Antriebsmechanismus (DM) 23,4%, Trennfähigkeit (BC) 12,3% und andere Faktoren (OF) 13,6%.

In einem anderen Beispiel werden bei einer gasisolierten Schaltanlage mit 400 kV Nennspannung die Betriebsteilzustände anders gewichtet: Isolationssystem 51,9%, Antriebsmechanismus 21,1%, Trennfähigkeit 7,7% und andere Faktoren 18,3%.

Die genannten Prozentzahlen für die beiden unterschiedlichen Arten von gasisolierten Schaltanlagen ergeben sich dabei aus Erfahrungswerten, die sich aus dem langjährigen Betrieb solcher Schaltanlagen ergeben. Dabei hatte sich beispielsweise gezeigt, dass die Komponenten des Isolationssystems zu 50,7 % aller Fehler der 132 kV Anlage beitragen. Aus diesem Grund wird eine entsprechende Gewichtung dieser Komponenten für den health index vorgenommen. Dieser und weitere Erfahrungswerte lassen sich z.B. der Studie "Report on the second international survey on high voltage gas insulated substations (GIS) service experience" von Cheung et al., erschienen in CIGRE TB 150, Issue 1, page 17 im Jahr 2000 entnehmen. Es ist jedoch auch die Verwendung anderer Quellen von Erfahrungswerten möglich, voraus sich möglicherweise jedoch eine abweichende Gewichtung als in diesen beiden Beispielen ergibt.

In einer weiteren bevorzugten Ausführungsform des erfindungsgemäßen Verfahrens wird jeder erfasste Messwert einer Komponente einem einzelnen Betriebsteilzustand zugeordnet, wobei jeder Messwert bei der Ermittlung des zugeordneten einzelnen Betriebsteilzustands mit einem relativen Anteil in den zugeordneten Betriebsteilzustand eingeht, indem für die zugeordnete Komponente der relative Anteil bestimmt wird, den diese Komponente am Fehleraufkommen aller Komponenten dieses einzelnen Betriebsteilzustands hat. Dies ist ein Vorteil, weil auf diese Weise besonders fehleranfällige Komponenten besonders stark bei der Berechnung des Betriebszustands berücksichtigt werden können.

Ein Beispiel für die Gewichtung von Komponenten anhand der bekannte Fehlerhäufigkeiten ist in der folgenden Tabelle jeweils für eine gasisolierte Schaltanlage mit 132 kV und mit 400 kV Nennspannung aufgeführt:

| Betriebsteilzustand | Komponente | GIS Typ 132 kV [%] | GIS 400 kV [%] |
|---|---|---|---|
| Isolationssystem | | 50,7 | 51,9 |
| | Hochspannungskomponenten | 16,3 | 18,3 |
| | metallisch geerdete Komponenten | 0,6 | 0,9 |
| | Gasisolierung | 6,5 | 12,5 |
| | Feststoffisolierung innerhalb GIS-Anlage | 10,4 | 15,4 |
| | SF6 Gasdichtung | 14,3 | 3,8 |
| | SF6 Gasdruck Überwachung | 2,6 | 1,0 |
| Antriebsmechanismus | | 23,4 | 22,1 |
| | Operationsmechanismus-Kompressor, Motoren, Pumpen, Rohrverbindungen | 7,2 | 6,7 |
| | Operationsmechanismus-Energiespeicher, mechanische Übersetzung, Aktuator und Dämpfer | 16,2 | 15,4 |
| Trennfähigkeit | | 12,3 | 7,7 |
| | Trennvorrichtung (z.B. Kammer, Schalter oder Trenneranordnung) | 9,1 | 4,8 |
| | Andere Hauptkontaktkomponenten (z.B. Kontaktbolzen) | 3,2 | 2,9 |
| Andere Faktoren | | 13,6 | 18,3 |

Zu den anderen Faktoren zählen beispielsweise Alter der Komponente, Wartungs-Compliance, Besichtigungs-Compliance, Besichtigungsergebnisse und Wartungsergebnisse. Außerdem werden Anlagenteile, denen - wie im Vorfeld beschrieben - noch nicht eine explizite Zuordnung für ihren Eingang in den Betriebszustand bekommen haben, bei anderen Faktoren angerechnet.

Gemäß einem anderen Beispiel ergibt sich für eine luftisolierte Schaltanlage der Mittelspannung mit 11 kV oder 33 kV Nennspannung folgende Gewichtung von Komponenten und Betriebsteilzuständen anhand der bekannten Fehlerhäufigkeiten:

| Betriebsteilzustand | Komponente | MV AIS 11kV/33kV [%] |
|---|---|---|
| Isolationssystem | | 9,9 |
| | Isolationsfehler | 1,9 |
| | Abnutzung elektrische Performance | 4,0 |
| | Abnutzung mechanische Isolationsperformance | 3,1 |
| | Elektrische Überspannung | 0,9 |
| Antriebsmechanismus | | 62,2 |
| | Schmutz und Verunreinigung | 4,7 |
| | Kontaktpositionierung/Einstellung | 1,4 |
| | Korrosion | 0,1 |
| | Undichtigkeit des Antriebs | 46,7 |
| | Gummierung | 7,3 |
| | Generelle mechanische Abnutzung des Antriebs | 2,1 |
| Trennfähigkeit | | 19,6 |

(fortgesetzt)

| Betriebsteilzustand | Komponente | MV AIS 11kV/33kV [%] |
|---|---|---|
| | Verbrauch Kontaktmaterial | 14,1 |
| | Materialermüdung Hauptkontakte | 1,0 |
| | Materialermüdung anderer Antriebskomponenten | 4,5 |
| Andere Faktoren | | 8,3 |

Dabei können für die luftisolierten Schaltanlagen in diesem Beispiel die gleichen anderen Faktoren wie bei gasisolierten Schaltanlagen herangezogen werden.

In einer weiteren bevorzugten Ausführungsform des erfindungsgemäßen Verfahrens wird festgestellt, welche Betriebsteilzustände korrelieren und jeweils für zwei korrelierende Betriebsteilzustände ein Quotient gebildet wird, wobei bei Unterschreiten eines unteren Schwellenwerts oder Überschreiten eines oberen Schwellenwerts des Quotienten ein Warnhinweis bereit gestellt wird, damit ein Wartungstermin vorgezogen werden kann.

Dies ist ein Vorteil, weil in der Regel davon ausgegangen wird, dass die Komponenten einer Anlage vergleichbar schnell altern; verschlechtert sich der Betriebszustand einer einzelnen Betriebszustandsdimension im Vergleich zu einer anderen Betriebszustandsdimension besonders stark, ist dies ein Hinweis auf einen möglicherweise bevorstehenden Fehler in einer Komponente der Anlage. In diesem Fall muss ein Wartungstermin vorgezogen werden, um einen Ausfall der Anlage zu verhindern.

In der nachfolgenden Tabelle ist beispielhaft für gasisolierte Schaltanlagen angegeben, wie stark sich die vier einzelnen Betriebsteilzustände beeinflussen. Dabei bezeichnet Level die Stärke der Beeinflussung und R einen Beeinflussungsparameter basierend auf Erfahrungsdaten, wie sie z.B. aus der vorgenannten Studie gewonnen werden können. So gibt es beispielsweise eine hohe Beeinflussung zwischen Antriebsmechanismus und Trennfähigkeit, d.h. Fehler beim Antrieb führen zu Fehlern bei der Schaltfähigkeit einer Anlage.

Die gegenseitige Beeinflussung wird durch den Beeinflussungsparameter R beschrieben, wobei R<0,15 als geringe Abhängigkeit, R zwischen 0,15 und 0,35 als mittlere Beeinflussung und R zwischen 0,35 und 0,5 als große Beeinflussung betrachtet wird.

Im der nachfolgenden Tabelle sind jeweils Beeinflussungsparameter R für gasisolierte Schaltanlagen aufgelistet:

| Beeinflussung | Level | R |
|---|---|---|
| IS-BC | niedrig | 0,08 |
| DM-BC | hoch | 0,42 |
| BC-IS | mittel | 0,24 |
| BC-DM | niedrig | 0,04 |
| OF-IS | mittel | 0,34 |
| OF-DM | mittel | 0,26 |
| OF-BC | niedrig | 0,06 |

Ein unterer Schwellenwert kann beispielsweise 0,8 und ein oberer Schwellenwert 1.25 sein, weil diese beiden Schwellenwerte sich in der Praxis bewährt haben.

In einer weiteren bevorzugten Ausführungsform des erfindungsgemäßen Verfahrens umfassen die komponentenspezifischen Alterungsfunktionen eine über die Zeit konstante Alterungsfunktion.

In einer weiteren bevorzugten Ausführungsform des erfindungsgemäßen Verfahrens umfassen die komponentenspezifischen Alterungsfunktionen eine linear zunehmend über die Zeit linear zunehmende Alterungsfunktion.

In einer weiteren bevorzugten Ausführungsform des erfindungsgemäßen Verfahrens umfassen die komponentenspezifischen Alterungsfunktionen eine über die Zeit exponentiell zunehmende Alterungsfunktion.

In einer weiteren bevorzugten Ausführungsform des erfindungsgemäßen Verfahrens umfassen die komponentenspezifischen Alterungsfunktionen eine über die Zeit exponentiell abnehmende Alterungsfunktion.

In einer weiteren bevorzugten Ausführungsform des erfindungsgemäßen Verfahrens wird anhand des zeitlichen Verlaufs des Betriebszustands ein zeitlicher Verlauf einer Ausfallwahrscheinlichkeit der Anlage bestimmt, wobei ein bekannter zeitlicher Verlauf der Ausfallwahrscheinlichkeit des Typs der Anlage berücksichtigt wird. Dies ist ein Vorteil, weil die Ausfallwahrscheinlichkeit der technischen Anlage eine wertvolle Information für die Entscheidung über den nächsten Wartungstermin oder einen ggf. nötigen Austausch der Anlage liefert.

In einer weiteren bevorzugten Ausführungsform des erfindungsgemäßen Verfahrens wird aus dem zeitlichen Verlauf der Ausfallwahrscheinlichkeit der Anlage unter Berücksichtigung der Folgen eines Ausfalls der Anlage ein zeitlicher Verlauf eines Ausfallrisikos bestimmt. Dies ist vorteilhaft, weil auf diese Weise Anlagen mit besonderer Bedeutung, z.B. für die Netzstabilität oder für die Versorgung wichtiger Infrastruktur wie Krankenhäuser oder dergleichen aufgrund der besonders gravierenden Folgen eines Ausfalls bei der Berechnung des Ausfallrisikos besonders berücksichtigt werden können. Ein Transformator, der einen Netzabschnitt mit einem Krankenhaus bedient, erhielte bei ansonsten gleichen Bedingungen ein höheres Ausfallrisiko zugeordnet als ein Transformator ohne besondere Bedeutung.

In einer weiteren bevorzugten Ausführungsform des erfindungsgemäßen Verfahrens umfasst das Ausfallrisiko mindestens eines der folgenden Risiken: die erwarteten Kosten eines Ausfalls, Investitionsausgaben, Betriebskosten, Umweltrisiko, Sicherheitsrisiko, Netzwerkperformancerisiko.

Dies ist ein Vorteil, weil eine Aufgliederung des Ausfallrisikos auf verschiedene Arten von Risiken eine besonders genaue Einschätzung des Risikos ermöglicht.

In einer weiteren bevorzugten Ausführungsform des erfindungsgemäßen Verfahrens umfassen die Folgen des Ausfalls der Anlage die vom Typ der Anlage und dem Standort der Anlage abhängigen Kosten des Ausfalls. Dies ist ein Vorteil, weil durch die Berücksichtigung der Kosten für die Wartung ein wichtiger wirtschaftlicher Faktor einbezogen wird. So kann beispielsweise eine besonders kostspielige Wartung bei ausreichenden Sicherheitsreserven heraus gezögert werden oder mit einem etwas späteren Wartungstermin einer anderen technischen Anlage im gleichen Gebiet koordiniert werden, um Anfahrtskosten zu sparen.

Generell können bei dem erfindungsgemäßen Verfahren Wartungstermine in der oben genannten Weise koordiniert werden, um an einem Tag und/oder bei einer Tour mehrere technische Anlagen warten zu können.

In einer weiteren bevorzugten Ausführungsform des erfindungsgemäßen Verfahrens werden bei der Berechnung des Ausfallrisikos zusätzlich eine Anlagenperformance und/oder eine Ersatzteilverfügbarkeit berücksichtigt.

In einer weiteren bevorzugten Ausführungsform des erfindungsgemäßen Verfahrens wird ein Zeitpunkt für den Austausch oder eine Instandsetzung der Anlage bestimmt, indem ein zeitlicher Verlauf des abgezinzten Neupreises der Anlage berechnet wird und das Minimum des zeitlichen Verlaufs der Summe aus Ausfallrisiko und abgezinztem Neupreis bestimmt wird. Dies ist ein Vorteil, weil dem Benutzer somit ständig ein Überblick über die durch die überwachten Anlagen repräsentierten Sachwerte gegeben wird.

Wird eine technische Anlage zu einem bestimmten Zeitpunkt ersetzt, so sind die entstehenden Kosten aus betriebswirtschaftlicher Sicht im Rahmen von Investitionsausgaben (englisch "Capital expenditure" CAPEX) zu betrachten. Im Gegensatz dazu ist eine Wartung oder Instandsetzung einer Anlage im Rahmen des operativen Geschäftsbetriebes (englisch "Operational expenditure" OPEX) zu betrachten.

Das erfindungsgemäße Verfahren liefert folglich Handlungsempfehlungen für das Management von technischen Anlagen, die mit Vorteil auf der Basis von Messungen eine besonders genaue Planung von Kosten ermöglichen.

In einer weiteren bevorzugten Ausführungsform des erfindungsgemäßen Verfahrens werden zusätzlich zu dem mindestens einen Messwert statische Werte zu Komponenten der Anlage und/oder regelmäßig manuell erfasste Werte bei der Ermittlung des Betriebszustands berücksichtigt. Dies ist vorteilhaft, weil auf diese Weise auch Erfahrungswissen eines Benutzers eingegeben werden kann.

In einer weiteren bevorzugten Ausführungsform des erfindungsgemäßen Verfahrens umfasst der mindestens eine Messwert mindestens einen der folgenden Messwerte: Temperatur, Druck, Spannung, Stromstärke, Druck eines Isolationsgases, Anzahl von Fehlermeldungen in einem gegebenen Zeitintervall, Anzahl von Alarmen in einem gegebenen Zeitintervall, Schaltleistung (in $I^2t$), $SF_6$ Gasfeuchte, $SF_6$ Reinheit, Schaltzeit für das Öffnen eines Schalters, Schaltzeit für das Schließen eines Schalters, Schaltspulenstrom, Anteil Gas in Öl bei einem ölgekühlten Transformator, "Top-Oil" Temperatur bei einem ölgekühlten Transformator.

In Abhängigkeit von dem Typ der überwachten elektrischen Anlage (z.B. eine Schaltanlage oder ein Transformator) können noch zahlreiche andere Messwerte mit Vorteil überwacht und ausgewertet werden.

In einer weiteren bevorzugten Ausführungsform des erfindungsgemäßen Verfahrens werden historische Daten des mindestens einen Messwerts aus einem Datenspeicher bei der Festlegung des nächsten Wartungstermins berücksichtigt. Dies ist ein Vorteil, weil hierdurch die Datengrundlage und somit die Genauigkeit bei der Bestimmung des nächsten Wartungstermins erhöht werden.

In einer weiteren bevorzugten Ausführungsform des erfindungsgemäßen Verfahrens wird der mindestens eine erfasste Messwert ständig in dem Datenspeicher den historischen Daten hinzugefügt. Dies ist vorteilhaft, weil so die Datengrundlage im Betrieb des Verfahrens ständig vergrößert wird.

In einer weiteren bevorzugten Ausführungsform des erfindungsgemäßen Verfahrens wird eine Vielzahl von Anlagen überwacht und es werden jeweils Durchschnittswerte und/oder Histogramme des Betriebszustands und/oder der Ausfallwahrscheinlichkeit und/oder des Ausfallrisikos der Vielzahl von Anlagen sowie des jeweiligen zeitlichen Verlaufs bestimmt. Dies ist ein Vorteil, weil somit bei mehreren überwachten Anlagen ein Überblick für den Benutzer geschaffen wird, um Aussagen über die gesamte Flotte von technischen Anlagen zu ermöglichen.

In einer weiteren bevorzugten Ausführungsform des erfindungsgemäßen Verfahrens werden Durchschnittswerte und/oder Histogramme derart gewichtet berechnet, dass unterschiedliche Typen von technischen Anlagen unterschiedlich stark in die Berechnung der Durchschnittswerte und/oder Histogramme einfließen. Dies ist vorteilhaft, weil unterschiedliche Arten von Anlagen für die Betrachtung der Gesamtflotte technischer Anlagen eine unterschiedlich große Bedeutung aufweisen können. Dabei kann die Gewichtung beispielsweise anhand von Erwartungswerten der wahrscheinlich nicht gelieferten Energie durch einen Ausfall einer technischen Anlage erfolgen. Je gravierender der Energieverlust sich ausprägt, desto höher wird eine Anlage nach diesem Modell gewichtet.

Die Erfindung betrifft ferner eine Anordnung für eine automatische Zustandsüberwachung einer elektrischen Anlage und stellt sich die Aufgabe, eine Anordnung bereit zu stellen, mit der technische Anlagen besonders effizient betrieben werden können.

Die Lösung dieser Aufgabe ist in Anspruch 14 angegeben. Es ergeben sich dabei sinngemäß die gleichen Vorteile wie eingangs bei dem erfindungsgemäßen Verfahren geschildert.

Des Weiteren ist Gegenstand der vorliegenden Erfindung ein Datenverarbeitungsprogramm zum Ausführen in einer Datenverarbeitungsanordnung, wobei das Datenverarbeitungsprogramm Teile eines Quellcodes zum Durchführen des erfindungsgemäßen Verfahrens umfasst, wenn das Programm auf der Datenverarbeitungsanordnung läuft.

Die Erfindung betrifft ferner ein Computerprogrammprodukt und stellt sich die Aufgabe, ein Computerprogrammprodukt anzugeben, mit dem auf einer Rechnereinrichtung ein Verfahren für ein besonders effizientes Betreiben von technischen Anlagen durchgeführt werden kann.

Die Lösung dieser Aufgabe ist in Anspruch 15 angegeben. Es ergeben sich dabei sinngemäß die gleichen Vorteile wie eingangs bei dem erfindungsgemäßen Verfahren geschildert.

Im Folgenden zeigt zur besseren Erläuterung der Erfindung

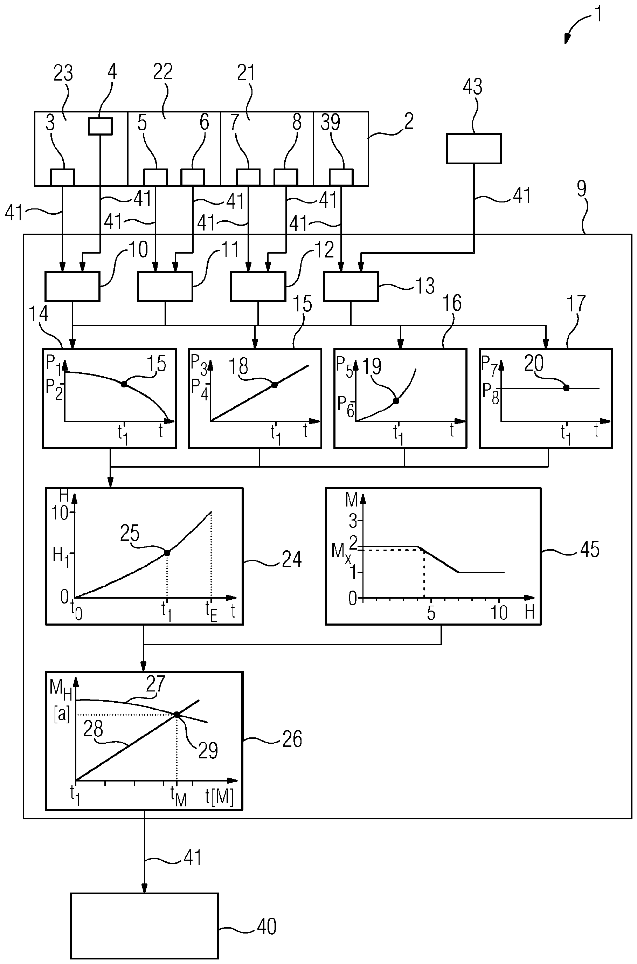

Figur 1      ein Ausführungsbeispiel der erfindungsgemäßen Anordnung in schematischer Darstellung.

Die erfindungsgemäße Anordnung 1 weist eine technische Anlage 2 auf, die automatisch auf ihren Zustand überwacht wird. Bei der Anlage 2 handelt es sich um eine gasisolierte Schaltanlage mit 400 kV Nennspannung.

Die Anlage 2 weist mehrere Komponenten 21,22,23 auf.

Die Komponente 21 ist ein Isolationssystem und wird mit zwei Sensoreinrichtungen 3,4 überwacht, wobei Sensoreinrichtung 3 die Schutzgasdichte überwacht und Sensoreinrichtung 4 die Gasabfeuchte überwacht.

Die Komponente 22 ist ein Antriebsmechanismus und wird mit zwei Sensoreinrichtungen 5,6 überwacht, wobei Sensoreinrichtung 5 die Öffnungszeit der Kontakte der Schaltanlage überwacht und Sensoreinrichtung 6 die Schließzeit der Kontakte der Schaltanlage überwacht.

Die Komponente 23 ist sind die für die Trennfähigkeit der Schaltanlage verantwortlichen Bauteile. Es kommen zwei Sensoreinrichtungen 7,8 zum Einsatz, wobei Sensoreinrichtung 7 den Nennstrom überwacht und Sensoreinrichtung 8 die Schaltleistung (in $i^2*t$) überwacht.

Mittels der Kommunikationsverbindungen 41 werden die von den Sensoreinrichtungen 3-8 erfassten Messwerte an eine Datenverarbeitungsanordnung 9 übermittelt. Die Kommunikationsverbindungen 41 können dabei Funkverbindungen, herkömmliche Kabelverbindungen, Verbindungen über das Internet oder Verbindungen, die Daten über ein Stromnetz übertragen, sein.

In einer alternativen Ausgestaltung können die erfassten Messwerte auch zuerst in einer zwischengeschalteten Auswerteeinrichtung gesammelt werden (nicht dargestellt).

Die Datenverarbeitungsanordnung 9 verwendet die Messwerte jeweils spezifisch für die Anlage, um einen Betriebszustand der Anlage zu ermitteln.

Hierfür werden die Messwerte, die von den Sensoreinrichtungen 5-8 erfasst werden, den Komponenten, die sie überwachen, zugeordnet. Die Komponenten der Anlage wiederrum werden vier Betriebsteilzuständen 10-13 zugeordnet.

Die Komponente 23 wird dem Betriebsteilzustand 10 zugeordnet, der die Komponenten des Isolationssystem (IS) umfasst, wobei der Betriebsteilzustand 10 mit 50,7% in die Ermittlung des Betriebszustands eingeht.

Die Komponente 22 wird dem Betriebsteilzustand 11 zugeordnet, der die Komponenten des Antriebsmechanismus (DM) umfasst, wobei der Betriebsteilzustand 11 mit 23,4% in die Ermittlung des Betriebszustands eingeht.

Die Komponente 21 wird dem Betriebsteilzustand 12 zugeordnet, der die Komponenten des Trennfähigkeit (BC) umfasst, wobei der Betriebsteilzustand 12 mit 12,3% in die Ermittlung des Betriebszustands eingeht.

Der Betriebsteilzustand 13 umfasst andere Faktoren (OF) und geht mit 13,6% in die Ermittlung des Betriebszustands ein. Die Sensoreinrichtung 39 misst einen Messwert, der noch keiner Hauptkomponente 21,22,23 der Anlage zugeordnet ist. Darüber hinaus gehen auch weitere Faktoren wie Alter der Komponente, Wartungs-Compliance, Besichtigungs-Compliance, Besichtigungsergebnisse und Wartungsergebnisse in den Betriebsteilzustand 13 ein, wobei diese aus einem Datenspeicher 43 mittels einer Datenübertragungsverbindung 41 übermittelt werden. Der Datenspeicher 43 kann durch einen Benutzer manuell befüllt werden. Alternativ kann der Datenspeicher 41 durch Übermittlung von Daten aus einem System für die Planung und Durchführung von Wartungen, Instandsetzungen und Ersetzungen von Anlagen befüllt werden.

Als nächste Schritte werden erfindungsgemäß die von den Sensoreinrichtungen 3-8 übermittelten Messdaten sowie die aus dem Datenspeicher 43 übermittelten Erfahrungsdaten benutzt, um die ermittelten Messdaten mit komponentenspezifischen Alterungsfunktionen altern zu lassen. Auf diese Weise können sowohl der aktuelle als auch der zukünftige Betriebszustand bestimmt werden. Beispiele für die Anwendung von Alterungsfunktionen sind in den Schritten 14 bis 17 dargestellt.

Die Berechnung einer exponentiell zunehmende Alterungsfunktion erfolgt beispielsweise für den Messwert Schließzeit, der von der Sensoreinrichtung 6 überwacht wird, folgendermaßen: die Lebenszeit der Komponente beträgt laut Hersteller 50 Jahre (Parameter L), ebenfalls laut Herstellerangaben beträgt die minimale Schließzeit 34ms ($OT_t$) und die maximale (zulässige) Schließzeit 38ms ($OT_{t+L}$). Der Umweltbedingungsfaktor für den Alterungsprozess wird für Anlagen in klimatisierten Räumen als vernachlässigbar angesehen (Parameter B=1); bei nicht-klimatisierten Anlagen wird ein Parameter B>1 gewählt, um die verstärke Alterung z.B. infolge von erhöhter Luftfeuchtigkeit oder Temperatur zu berücksichtigen. Gemäß der Gleichung

$$OT_{t+L} = OT_t * (1+B*C)^T$$

ergibt sich für den Exponentialfaktor C ein Wert von ca. 0,002. Entsprechend obiger Gleichung kann der zukünftige zeitliche Verlauf der Schließzeit vom aktuellen Datum an berechnet werden. In vergleichbarer Weise werden auch exponentiell abnehmende, linear zunehmende und konstante Alterungsfunktionen anhand bekannter Herstellerangaben ermittelt.

Beispielsweise werden bei 400kV GIS-Schaltanlagen folgende Messwerte mittels einer exponentiell abnehmenden Alterungsfunktion gealtert: Gasreinheit, Gastaupunkt.

Beispielsweise werden bei 400kV GIS-Schaltanlagen folgende Messwerte mittels einer exponentiell zunehmenden Alterungsfunktion gealtert: Schließzeit, Öffnungszeit, Strom einer offenen Spule, Strom einer geschlossenen Spule, Kompressionsmotorstrom für eine Feder, Schaltleistung.

Beispielsweise werden bei 400kV GIS-Schaltanlagen folgende Messwerte mittels einer linear ansteigenden Alterungsfunktion gealtert: Anzahl von Trennfehlern, Teilentladung, Laufzeit des Motors für einen Federantrieb, Anzahl Operationen der Anlage, Anzahl der Fehler beim Schließen, Laststrom, Altersparameter der Anlage.

Beispielsweise werden bei 400kV GIS-Schaltanlagen folgende Messwerte mittels einer konstanten Alterungsfunktion gealtert bzw. konstant gehalten: Besichtigungs-Compliance, Wartungs-Compliance, Wartungsergebnisse.

Schritt 14 zeigt eine Anwendung einer exponentiell abnehmenden Alterungsfunktion auf einen Messwert $P_1$ für eine Komponente, so dass sich der aktuelle Messwert 15 vom gegenwärtigen Zeitpunkt t1 und Messwert $P_2$ aus exponentiell verschlechtert. Beispielsweise verschlechtert sich der Gastaupunkt exponentiell.

In ähnlicher Weise zeigt Schritt 15 die Auswirkung einer linearen Alterungsfunktion auf einen Messwert $P_3$ ausgehend vom aktuellen Messwert 18 am Messpunkt $t_1$, $P_4$; Schritt 16 die Auswirkung einer exponentiell zunehmenden Alterungsfunktion auf einen Messwert $P_5$ ausgehend vom aktuellen Messwert 19 am Messpunkt $t_1$, $P_6$.

Schritt 17 zeigt die Auswirkung einer konstanten Alterungsfunktion (Betriebszustand bleibt über die Zeit gleich) auf einen Messwert $P_7$ ausgehend vom aktuellen Messwert 20 am Messpunkt $t_1$, $P_8$.

In ähnlicher Weise werden alle erfassten Messwerte ab dem Datum ihrer Erfassung gealtert, um einen Verlauf eines Betriebszustands für den jeweiligen Betriebsteilzustand 10-13 zu gewinnen (nicht gezeigt).

Die Betriebsteilzustände werden wie eingangs geschildert gewichtet zusammengefasst und ergeben einen zeitlichen Verlauf des Betriebszustands der gesamten Anlage 2, wie er in Schritt 24 dargestellt ist.

Der Betriebszustand H verschlechtert sich von der Inbetriebnahme $t_0$ der Anlage vom Wert null bis zum Betriebsende der Anlage $t_E$ auf einen Wert von 10. Zum aktuellen Zeitpunkt $t_1$ ergibt sich ein Betriebszustand $H_1$ mit einem Wert 4,5, der durch den Punkt 25 auf der Betriebszustandskurve gekennzeichnet ist.

Weiterhin liegt eine Abhängigkeit eines vorgesehenen Wartungsintervalls M (in Jahren a bemessen) vom Betriebszustand vor, wie in der Abbildung 45 schematisch dargestellt. Je schlechter der Betriebszustand einer Anlage, desto geringer wird das Wartungsintervall eingestellt. Im gezeigten Beispiel hat eine neuwertige Anlage mit Betriebszustandswert 0 ein Wartungsintervall von 2 Jahren, das sich ab einem Betriebszustand von 4 verringert, bis es bei einem Betriebszustand von 7 ein Wartungsintervall von 1 Jahr erreicht. Bei dem aktuellen Betriebszustand von 4,5 aus Schritt 24 ergibt sich somit ein aktuelles Wartungsintervall von $M_x$, also ca. 1,83 Jahre.

Es ist jedoch zu berücksichtigen, dass nun nicht einfach ein Wartungstermin festgesetzt werden kann, der 1,83 Jahre nach der letzten Wartung liegt. Dabei würde nämlich unberücksichtigt bleiben, dass sich in der Zeit von jetzt bis zum Wartungstermin aufgrund der Alterung der Anlage der Betriebszustand weiter verschlechtern würde und entsprechend auch das Wartungsintervall verkürzt werden müsste. Ohne eine Korrekturrechnung würde der Wartungstermin also regelmäßig zu weit in der Zukunft angesetzt und ein Ausfall oder Fehler der Anlage riskiert.

Aus diesem Grund wird in Schritt 26 ein Abgleich zwischen dem Verlauf des an den jeweiligen Betriebszustand angepassten Wartungsintervalls 27, das stetig sinkt, und einem linearen Zeitstrahl 28, der die Monate ab dem aktuellen Datum dargestellt, vorgenommen. Wo die beiden Kurven sich treffen, wird der nächste Wartungstermin $t_M$, gekennzeichnet durch Punkt 29, festgelegt.

Der festgelegte Wartungstermin $t_M$, der aktuelle Betriebszustand H1 sowie der zukünftige zeitliche Verlauf des Betriebszustands werden mittels einer weiteren Kommunikationsverbindung 41 an eine Anzeigevorrichtung übermittelt und zur Ablesung durch einen Benutzer dargestellt.

In einer Fortbildung des Systems ist es außerdem möglich, den festgelegten Wartungstermin $t_M$ an ein System zur Planung von Wartungsarbeiten zu übermitteln. Dieses System kann dann unter Berücksichtigung von Mitarbeiterarbeitsplänen, geografischen Informationen zu Wegstrecken und Anlagenstandorten sowie ggf. Wetterprognosen eine geeignete Tour zur Wartung, Instandsetzung oder Ersetzung dieser Anlage und weiterer Anlagen mit zeitlich nah beieinander liegenden festgelegten Wartungsterminen planen und für einen Benutzer bereit stellen.

## Patentansprüche

1.  Verfahren für eine automatische Zustandsüberwachung einer technischen Anlage (2), bei dem

    mittels mindestens einer Sensoreinrichtung (5-8,39) an der Anlage (2) mindestens ein Messwert mindestens einer Komponente (21, 22, 23) der Anlage (2) erfasst wird und in einer Datenverarbeitungsanordnung (9) jeweils spezifisch für die Anlage (2) der mindestens eine Messwert für eine Ermittlung eines aktuellen Betriebszustands ($H_1$) der Anlage (2) verwendet wird, und

    mittels der Datenverarbeitungsanordnung (9) unter Einbeziehung komponentenspezifischer Alterungsfunktionen mittels des aktuellen Betriebszustands ($H_1$) ein zukünftiger zeitlicher Verlauf des Betriebszustands ermittelt wird, und anhand des zukünftigen zeitlichen Verlaufs des Betriebszustands ein Wartungsintervall (M) für die Anlage (2) angepasst wird, um einen nächsten Wartungstermin ($t_M$) der Anlage (2) automatisch festzulegen,
    **dadurch gekennzeichnet, dass**
    der Betriebszustand (H1) der technischen Anlage (2) aus mehreren Betriebsteilzuständen (10-13) ermittelt wird, wobei den einzelnen Betriebsteilzuständen (10-13) jeweils einzelne Komponenten (21,22,23) der Anlage (2) zugeordnet sind und wobei die einzelnen Betriebsteilzustände (10-13) jeweils gewichtet herangezogen werden.

2.  Verfahren nach Anspruch 1,
    **dadurch gekennzeichnet, dass**
    die Festlegung des nächsten Wartungstermins ($t_m$) anhand des mindestens einen erfassten Messwerts ständig aktualisiert wird.

3.  Verfahren nach Anspruch 1 oder 2,
    **dadurch gekennzeichnet, dass**
    das Wartungsintervall (M) angepasst wird, indem ein vorgegebenes Wartungsintervall jeweils für einen nachfolgenden Zeitpunkt mit festgelegtem zeitlichen Abstand zum aktuellen Datum unter Berücksichtigung des aus dem zukünftigen zeitlichen Verlauf des Betriebszustands bekannten Betriebszustands an dem nachfolgenden Zeitpunkt angepasst wird, wobei das zum nachfolgenden Zeitpunkt bestimmte Wartungsintervall ein vorgegebenes Wartungsintervall für den nächsten nachfolgenden Zeitpunkt ist, bis das Wartungsintervall so verkleinert ist, dass es mit einem nachfolgenden Zeitpunkt zusammenfällt oder vor diesem Zeitpunkt liegt.

4.  Verfahren nach einem der vorhergehenden Ansprüche,
    **dadurch gekennzeichnet, dass**
    die Gewichtung eines einzelnen Betriebsteilzustands (10-13) anhand eines vorbekannten gesamten Fehleraufkommens bei dem Typ der Anlage (2) bestimmt wird, indem für die zugeordneten Komponenten (21, 22, 23) der relative Anteil bestimmt wird, den diese Komponenten (21,22,23) am gesamtem Fehleraufkommen haben.

5.  Verfahren nach Anspruch 4,
    **dadurch gekennzeichnet, dass**
    jeder erfasste Messwert einer Komponente (21,22,23) einem einzelnen Betriebsteilzustand (10-13) zugeordnet wird, wobei jeder Messwert bei der Ermittlung des zugeordneten einzelnen Betriebsteilzustands (10-13) mit einem relativen Anteil in den zugeordneten Betriebsteilzustand (10-13) eingeht, indem für die zugeordnete Komponente (21,22,23) der relative Anteil bestimmt wird, den diese Komponente (21,22,23) am Fehleraufkommen aller Komponenten (21,22,23) dieses einzelnen Betriebsteilzustands (10-13) hat.

6. Verfahren nach einem der vorhergehenden Ansprüche,
**dadurch gekennzeichnet, dass** festgestellt wird, welche Betriebsteilzustände (10-13) korrelieren und jeweils für zwei korrelierende Betriebsteilzustände (10-13) ein Quotient gebildet wird,
wobei bei Unterschreiten eines unteren Schwellenwerts oder Überschreiten eines oberen Schwellenwerts des Quotienten ein Warnhinweis bereit gestellt wird, damit ein Wartungstermin ($t_M$) vorgezogen werden kann.

7. Verfahren nach einem der vorhergehenden Ansprüche,
**dadurch gekennzeichnet, dass**
anhand des zeitlichen Verlaufs des Betriebszustands ein zeitlicher Verlauf einer Ausfallwahrscheinlichkeit der Anlage (2) bestimmt wird, wobei ein
bekannter zeitlicher Verlauf der Ausfallwahrscheinlichkeit des Typs der Anlage (2) berücksichtigt wird.

8. Verfahren nach Anspruch 7,
**dadurch gekennzeichnet, dass**
aus dem zeitlichen Verlauf der Ausfallwahrscheinlichkeit der Anlage (2) unter Berücksichtigung der Folgen eines Ausfalls der Anlage (2) ein zeitlicher Verlauf eines Ausfallrisikos bestimmt wird.

9. Verfahren nach Anspruch 8,
**dadurch gekennzeichnet, dass**
die Folgen des Ausfalls der Anlage (2) die vom Typ der Anlage (2) und dem Standort der Anlage (2) abhängigen Kosten des Ausfalls umfassen.

10. Verfahren nach einem der Ansprüche 8 oder 9,
**dadurch gekennzeichnet, dass**
bei der Berechnung des Ausfallrisikos zusätzlich eine Anlagenperformance und/oder eine Ersatzteilverfügbarkeit berücksichtigt werden.

11. Verfahren nach einem der vorhergehenden Ansprüche,
**dadurch gekennzeichnet, dass**
ein Zeitpunkt für den Austausch oder eine Instandsetzung der Anlage (2) bestimmt wird, indem ein zeitlicher Verlauf des abgezinzten Neupreises der Anlage (2) berechnet wird und das Minimum des zeitlichen Verlaufs der Summe aus Ausfallrisiko und abgezinztem Neupreis bestimmt wird.

12. Verfahren nach einem der vorhergehenden Ansprüche,
**dadurch gekennzeichnet, dass**
eine Vielzahl von Anlagen (2) überwacht wird und jeweils Durchschnittswerte und/oder Histogramme des Betriebszustands und/oder der Ausfallwahrscheinlichkeit und/oder des Ausfallrisikos der Vielzahl von Anlagen sowie des jeweiligen zeitlichen Verlaufs bestimmt werden.

13. Anordnung (1) für eine automatische Zustandsüberwachung einer elektrischen Anlage (2), mit
mindestens einer Sensoreinrichtung (3-8, 39), die an der technischen Anlage (2) angeordnet und zur Erfassung mindestens eines Messwerts mindestens einer Komponente (21, 22, 23) der Anlage (2) ausgelegt ist, und mit einer Datenverarbeitungsanordnung (9), die geeignet ist, jeweils spezifisch für die Anlage (2) den mindestens einen Messwert für eine Ermittlung eines aktuellen Betriebszustands ($H_1$) der Anlage (2) zu verwenden,
wobei die Datenverarbeitungsanordnung (9) geeignet ist, unter Einbeziehung komponentenspezifischer Alterungsfunktionen mittels des aktuellen Betriebszustands ($H_1$) einen zukünftigen zeitlichen Verlauf des Betriebszustands zu ermitteln und anhand des zukünftigen zeitlichen Verlaufs des Betriebszustands ein Wartungsintervall (M) für die Anlage anzupassen, um einen nächsten Wartungstermin ($t_M$) der Anlage automatisch festzulegen, **dadurch gekennzeichnet, dass** der Betriebszustand (H1) der technischen Anlage (2) aus mehreren Betriebsteilzuständen (10-13) ermittelt wird, wobei den einzelnen Betriebsteilzuständen (10-13) jeweils einzelne Komponenten (21, 22, 23) der Anlage (2.) zugeordnet sind und wobei die einzelnen Betriebsteilzustände (10-13) jeweils gewichtet herangezogen werden.

14. Computerprogrammprodukt, das in einem computerlesbaren Medium gespeichert ist und computerlesbare Programmmittel umfasst, mittels derer ein Computer als Datenverarbeitungsanordnung und/oder eine Cloud-basierte Datenverarbeitungsanordnung veranlasst werden, ein Verfahren nach einem der Ansprüche 1 bis 13 durchzuführen, wenn das Computerprogrammprodukt auf dem Computer und/oder der Cloud-basierten Datenverarbeitungsanordnung läuft.

**Claims**

1. Method for an automatic condition monitoring of a technical installation (2) in which
by means of at least one sensor device (5-8, 39) at the installation (2) at least one measured value of at least one component (21, 22, 23) of the installation (2) is recorded and the at least one measured value is used in a data-processing arrangement (9), in each case specifically for the installation (2), for the determination of a current operating condition ($H_1$) of the installation (2), and
by means of the data processing arrangement (9) a future chronological course of the operating condition is determined making use of component-specific ageing functions on the basis of the current operating condition ($H_1$), and that
on the basis of the future chronological course of the operating condition, a maintenance interval (M) is adjusted for the installation (2), in order to automatically specify a next maintenance date ($t_M$) of the installation (2),
**characterized in that**
the operating condition (H1) of the technical installation (2) is determined from a plurality of partial operating conditions (10-13), wherein individual components (21, 22, 23) of the installation (2) are each allocated to the individual partial operating conditions (10-13), and wherein the individual partial operating conditions (10-13) are each used in a weighted manner.

2. Method according to Claim 1,
**characterized in that**
the specification of the next maintenance date ($t_M$) is continuously updated on the basis of the at least one recorded measured value.

3. Method according to Claim 1 or 2,
**characterized in that**
the maintenance interval (M) is adjusted, **in that** a prespecified maintenance interval respectively for a subsequent point in time with a specified time interval from the current date is adjusted taking into account the operating condition at the subsequent point in time known from the future chronological course of the operating condition, wherein the maintenance interval determined until the subsequent point in time is a predetermined maintenance interval for the next subsequent point in time, until the maintenance interval has become so short that it coincides with a subsequent point in time or lies before this point in time.

4. Method according to one of the previous claims,
**characterized in that**
the weighting of an individual partial operating condition (10-13) is determined on the basis of a known total fault rate for the type of the installation (2), **in that** the relative proportion that the allocated components (21, 22, 23) have in the total fault rate is determined for these components (21, 22, 23).

5. Method according to Claim 4,
**characterized in that**
each recorded measured value of a component (21, 22, 23) is allocated to an individual partial operating condition (10-13), wherein each measured value is included in the determination of the allocated individual partial operating condition (10-13) with a relative proportion in the allocated partial operating condition (10-13), **in that** for the allocated component (21, 22, 23) the relative proportion that this component (21, 22, 23) has in the fault rate of all the components (21, 22, 23) of this individual partial operating condition (10-13) is determined.

6. Method according to one of the previous claims,
**characterized in that**
it is established which partial operating conditions (10-13) correlate, and a quotient is formed for each two correlating partial operating conditions (10-13),
wherein, when the quotient falls below a lower threshold value or exceeds an upper threshold value, a warning message is issued, so that a maintenance date ($t_M$) can be brought forward.

7. Method according to one of the previous claims,

**EP 3 155 490 B1**

a chronological course of a failure probability of the installation (2) is determined on the basis of the chronological course of the operating condition, wherein a known chronological course of the failure probability of the type of the installation (2) is taken into account.

8. Method according to Claim 7,
**characterized in that**
a chronological course of a risk of failure is determined from the chronological course of the failure probability of the installation (2), taking into account the consequences of a failure of the installation (2).

9. Method according to Claim 8,
**characterized in that**
the consequences of the failure of the installation (2) include the costs of the failure that depend on the type of the installation (2) and the location of the installation (2).

10. Method according to one of Claims 8 or 9,
**characterized in that**
an installation performance and/or an availability of spare parts is also taken into account in the calculation of the failure risk.

11. Method according to one of the previous claims,
**characterized in that**
a point in time for the exchange or repair of the installation (2) is determined, **in that** a chronological course of the discounted new price of the installation (2) is calculated, and the minimum of the chronological course of the total of the failure risk and the discounted new price is determined.

12. Method according to one of the previous claims,
**characterized in that**
a large number of installations (2) are monitored, and in each case average values and/or histograms of the operating condition and/or of the failure probability and/or of the failure risk of the large number of installations and of the respective chronological course, are determined.

13. Arrangement (1) for an automatic condition monitoring of an electrical installation (2), with
at least one sensor device (3-8, 39) which is arranged at the technical installation (2) and is designed to record at least one measured value of at least one component (21, 22, 23) of the installation (2), and with
a data processing arrangement (9) suitable to use, in each case specifically for the installation (2), the at least one measured value for a determination of a current operating condition ($H_1$) of the installation (2),
wherein
the data processing arrangement (9) is suitable for determining a future chronological course of the operating condition making use of component-specific ageing functions on the basis of the current operating condition ($H_1$), and for adjusting a maintenance interval (M) for the installation on the basis of the future chronological course of the operating condition, in order to automatically specify a next maintenance date ($t_M$) of the installation,
**characterized in that**
the operating condition (H1) of the technical installation (2) is determined from a plurality of partial operating conditions (10-13), wherein individual components (21, 22, 23) of the installation (2) are each allocated to the individual partial operating conditions (10-13), and wherein the individual partial operating conditions (10-13) are each used in a weighted manner.

14. Computer program product that is stored in a computer-readable medium and comprises computer-readable program means, by means of which a computer as a data-processing arrangement and/or a cloud-based data processing arrangement is/are caused to carry out a method according to one of Claims 1 to 13, when the computer program product runs on the computer and/or the cloud-based data-processing arrangement.

**Revendications**

1. Procédé de contrôle automatique de l'état d'une installation (2) technique, dans lequel
au moyen d'au moins un dispositif (5 à 8, 39) de capteur, on relève, sur l'installation (2), au moins une valeur de

12

mesure d'au moins un élément (22, 23) de l'installation (2) et, dans un système (9) de traitement de données spécifique à l'installation (2), on utilise la au moins une valeur de mesure pour déterminer un état (H$_1$) de fonctionnement instantané de l'installation (2) et

au moyen du système (9) de traitement de données, en incorporant des fonctions de vieillissement spécifiques aux éléments, on détermine, au moyen de l'état (H$_1$) de fonctionnement instantané, une courbe dans le temps à venir de l'état de fonctionnement et

à l'aide de la courbe dans le temps à venir de l'état de fonctionnement, on adapte un intervalle (M) d'entretien de l'installation (2), afin de fixer automatiquement le délai (t$_M$) d'entretien suivant de l'installation (2),

**caractérisé en ce que**

on détermine l'état (H$_1$) de fonctionnement de l'installation (2) technique à partir de plusieurs sous-états (10 à 13) de fonctionnement, divers éléments (21, 22, 23) de l'installation étant associés aux divers sous-états (10 à 13) de fonctionnement et les divers sous-états (10 à 13) de fonctionnement étant mis à profit respectivement de manière pondérée.

2. Procédé suivant la revendication 1,
**caractérisé en ce que**
l'on met à jour constamment la fixation du délai (t$_M$) d'entretien suivant immédiatement à l'aide d'au moins une valeur de mesure détectée.

3. Procédé suivant la revendication 1 ou 2,
**caractérisé en ce que**
l'on adapte l'intervalle (M) d'entretien en adaptant un intervalle d'entretien donné à l'avance respectivement pour un instant suivant, ayant une distance dans le temps fixée à la date présente, en tenant compte de l'état de fonctionnement à l'instant suivant, connu à partir de la courbe dans le temps à venir de l'état de fonctionnement, l'intervalle d'entretien déterminé à l'instant suivant étant un intervalle d'entretien donné à l'avance pour l'instant suivant immédiatement, jusqu'à ce que l'intervalle d'entretien soit si diminué qu'il coïncide avec l'instant suivant ou soit avant cet instant.

4. Procédé suivant l'une des revendications précédentes,
**caractérisé en ce que**
l'on détermine la pondération d'un sous-état (10 à 13) de fonctionnement à l'aide de l'apparition d'ensemble de défauts connue à l'avance dans le type de l'installation (2), en déterminant, pour les éléments (21, 22, 23) associés, la proportion relative qu'ont ces éléments (21, 22, 23) à l'apparition de défauts dans l'ensemble.

5. Procédé suivant la revendication 4,
**caractérisé en ce que**
l'on associe chaque valeur de mesure détectée d'un élément (21, 22, 23) à un sous-état (10 à 13) de fonctionnement, chaque valeur de mesure entrant dans la détermination du sous-état (10 à 13) de fonctionnement associé par une proportion relative dans le sous-état (10 à 13) de fonctionnement associé, par le fait que l'on détermine, pour l'élément (21, 22, 23) associé, la proportion relative que cet élément (21, 22, 23) a dans l'apparition de défauts de tous les éléments (21, 22, 23) de ce sous-état (10 à 13) de fonctionnement.

6. Procédé suivant l'une des revendications précédentes,
**caractérisé en ce que**
l'on constate les sous-états (10 à 13) de fonctionnement, qui sont corrélés et on forme un quotient respectivement pour deux sous-états (10 à 13) de fonctionnement corrélés,
dans lequel, si l'on passe en dessous d'une valeur de seuil inférieure ou si l'on dépasse une valeur de seuil supérieure du quotient, on met à disposition une indication d'avertissement, afin de pouvoir préférer un délai (t$_M$) d'entretien.

7. Procédé suivant l'une des revendications précédentes,
**caractérisé en ce que**,
à l'aide de la courbe dans le temps de l'état de fonctionnement, on détermine une courbe dans le temps d'une probabilité de défaillance de l'installation (2), dans lequel on prend en compte une courbe dans le temps connue de la probabilité de défaillance du type de l'installation (2).

8. Procédé suivant la revendication 7,
**caractérisé en ce qu'**
à partir de la courbe dans le temps de la probabilité de défaillance de l'installation (2) et en tenant compte de la conséquence d'une défaillance de l'installation (2), on détermine une courbe dans le temps d'un risque de défaillance.

9. Procédé suivant la revendication 8,
**caractérisé en ce que**
les conséquences de la défaillance de l'installation (2) comprennent les coûts de la défaillance en fonction du type de l'installation (2) et du lieu où se trouve l'installation 2.

10. Procédé suivant l'une des revendications 8 et 9,
**caractérisé en ce que**,
lors des calculs du risque de défaillance, on tient compte, en outre, d'une performance de l'installation et/ou d'une disponibilité partielle de remplacement.

11. Procédé suivant l'une des revendications précédentes,
**caractérisé en ce que**
l'on détermine un instant d'échange ou d'une réparation de l'installation (2), en calculant une courbe, en fonction du temps, du nouveau prix actualisé et on détermine le minimum de la courbe, en fonction du temps, de la somme du risque de défaillance et du nouveau prix actualisé.

12. Procédé suivant l'une des revendications précédentes,
**caractérisé en ce que**
l'on contrôle une pluralité d'installations (2) et on détermine chaque valeur moyenne et/ou histogramme de l'état de fonctionnement et/ou de la probabilité de défaillance et/ou du risque de défaillance de la pluralité d'installations, ainsi que la courbe respective en fonction du temps.

13. Système (1) de contrôle automatique de l'état d'une installation (2) électrique, comprenant
au moins un dispositif (3 à 8, 39) de capteur, qui est monté sur l'installation (2) technique et qui est conçu pour détecter au moins une valeur de mesure d'au moins un élément (21, 22, 23) de l'installation (2) et comprenant un système (9) de traitement de données propre à utiliser, spécifiquement pour l'installation (2), la au moins une valeur de mesure pour déterminer un état $(H_1)$ de fonctionnement instantané de l'installation (2),
dans lequel
le système (9) de traitement de données est propre à déterminer, en incorporant des fonctions de vieillissement spécifiques aux éléments, au moyen de l'état $(H_1)$ de fonctionnement instantané, une courbe à venir dans le temps, de l'état de fonctionnement et, à l'aide de la courbe à venir dans le temps de l'état de fonctionnement, à adapter un intervalle (M) d'entretien de l'installation pour fixer automatiquement un délai $(t_M)$ d'entretien suivant immédiatement de l'installation, **caractérisé en ce que** l'état (H1) de fonctionnement de l'installation (2) technique est déterminé à partir de plusieurs sous-états (10 à 13) de fonctionnement, dans lequel aux divers sous-états (10 à 13) de fonctionnement sont associés respectivement divers élément (21, 22, 23) de l'installation (2) et dans lequel les divers sous-états (10 à 13) de fonctionnement sont mis à profit respectivement de manière pondérée.

14. Produit de programme d'ordinateur, qui est mémorisé dans un support déchiffrable par ordinateur et qui comprend des moyens de programme déchiffrables par ordinateur, au moyen desquels un ordinateur, comme système de traitement de données et/ou un système de traitement de données reposant sur le cloud font qu'il est effectué un procédé suivant l'une des revendications 1 à 13 lorsque le produit de programme d'ordinateur passe sur l'ordinateur et/ou sur le système de traitement de données reposant sur le cloud.

1

23    4    22    21

43

3    5    6    7    8    39    2

41    41    41    41    41    9

41    41    41    41

10    11    12    13

14    15    16    17

P₁
P₂    15

P₃    18
P₄

P₅    19
P₆

P₇    20
P₈

t₁    t         t₁    t         t₁    t         t₁    t

H
10

25

H₁    24

0
t₀    t₁    tE    t

M
3

2
Mₓ    45

1

0         5    10    H

M_H    27

[a]
28    29    26

t₁    t_M    t[M]

41

40

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2549415 A1
- DE 102010049909 A1
- DE 102007029248 A1

**In der Beschreibung aufgeführte Nicht-Patentliteratur**

- **L. CHEIM ; P. LORIN ; P. KHANNA.** Trafotech 2014 - Session V: Towards Maintenance Free Transformers. *Dynamic Fleet Wide Condition Assessment Tool of Power Transformers*
- **CHEUNG et al.** Report on the second international survey on high voltage gas insulated substations (GIS) service experience. *CIGRE TB,* 2000, vol. 150 (1), 17